# EUROPEAN PATENT APPLICATION

(11) **EP 1 918 764 A1**
(43) Date of publication of application: **07.05.2008**
(21) Application number: 07021449.9
(22) Date of filing: 05.11.2007
(51) Int. Cl.: G02F 1/13, G02F 1/167, H05K 1/00, G02F 1/1333, H04M 1/02

(54) **Multi-panel display apparatus**

(30) Priority: 06.11.2006 KR 20060109134
(71) Applicant: Samsung Electronics Co., Ltd., Yeongtong-gu Suwon-city, Gyeonggi-do 442-742 (KR)
(72) Inventor: Kim, Sang-Il, Yongin-si Gyeonggi-do (KR)
(74) Representative: Dr. Weitzel & Partner

(57) **Abstract**

A display apparatus includes a main display panel displaying a first image by means of a backlit Liquid Crystal Display (LCD), a sub-display panel displaying a different second image by using electrophoretic particles having respective electrical polarities and colors, and a main printed circuit board providing image signals to the main display panel and to the sub-display panel. The main printed circuit board has field generating electrodes disposed on major surface thereof where the sub-display panel attaches so that electric fields generated by the field generating electrodes actuate the electrophoretic particles.

## Description

### CROSS-REFERENCE TO RELATED APPLICATION

This application claims priority from Korean Patent Application No. 2006-109134 filed on November 6, 2006, the disclosure of which is herein incorporated by reference in its entirety.

### BACKGROUND

### 1. Field of Invention

The present disclosure of invention relates to a display apparatus. More particularly, the present disclosure relates to a display apparatus including a plurality of display panels.

### 2. Description of Related Technology

Display apparatuses for displaying an image are often used in various electronic products, and are designed to have a structure suitable for use of the specific electronic products. Recently, a portable communications terminal such as a cellular phone has been designed in a compact and slim structure with lightweight to allow a user to easily carry and use the portable terminal.

In general, cellular phones include two classes, namely, a flip-type cellular phone and a folder-type or clamshell cellular phone. The flip-type cellular phone includes a liquid crystal display that Is always exposed on its outside to display the image, and a key pad that controls functions of the cell phone. The key pad may be always exposed on the outside also or it may be covered with a flap that the user flips open to expose keys of the key pad. Meanwhile, the liquid crystal display of the folder-type (clamshell type) cellular phone faces the key pad when the phone is folded into a closed state, and the display-supporting portion has user-operatable Input keys that are electrically connected with the keypad circuitry by a hinge.

In particular, the folder-type subclass of cellular phones may be further subdivided into a single panel type folder cellular phone and a dual panel type folder cellular phone. The single panel type cellular phone includes one display panel displaying an image, whereas the dual panel type cellular phone includes two display panels which are capable of displaying different images. That is, the dual panel type cellular phone typically includes a main display panel displaying a main image and a subsidiary or sub-display panel displaying a standby image (for example, a time, a date, an RF receiving sensitivity, etc.). The main display panel and the sub-display panel of the dual panel type cellular phone are typically both structured as liquid crystal display (LCD) panels, However, for purposes of back lighting, an organic light emitting device is generally applied only to the sub-display panel of the dual panel type cellular phone while a different light source is used for the main display panel.

The main display panel and the sub-display panel generally each includes two thick glass substrates, respectively; one being a common electrode substrate that supports a transparent common electrode and the other being a spaced-apart switching elements matrix substrate that supports a matrix of pixel electrodes and associated electronic switches. There is therefore a limitation in reduction of the total thickness and weight of the dual panel type cellular phone due to the inclusion of the four glass (or other transparent) substrates. In addition, if the main display panel and the sub-display panel receive LCD backlighting from different backlight assemblies, respectively, the dual panel type cellular phone requires two backlight assemblies, thus also increasing the thickness thereof.

### SUMMARY

The present disclosure provides a display apparatus capable of exhibiting a reduced thickness and/or a reduced weight,

In accordance with one aspect of the disclosure, there Is provided a dual sided printed circuit board having a top major side and a bottom major side where the top major side is structured to receive, support and operate a side lighting source for a main display panel, which main panel that is disposable above the top major side and where the bottom major side is structured to receive, support and partially define a subsidiary display panel that is disposable below the bottom major side. In one embodiment, the bottom major side includes field electrodes of the subsidiary display panel that define electric fields of the subsidiary display panel. In one embodiment, the subsidiary display panel includes electrophoretic particles disposed for forming an image in response to electric fields defined by the field electrodes of the bottom major side of the dual sided printed circuit board.

According to another aspect of the present disclosure, a multi-panel display apparatus is provided and includes a main display panel, a main flexible circuit unit, a light source and a sub-display panel that is lesser in display area and/or display resolution than the main display panel. The main display panel receives a first image signal and displays a corresponding first image of predefined maximum size and predefined maximum resolution. The main flexible printed circuit unit has a field-defining electrode layer disposed on a lower surface thereof for defining electric fields of the sub-display panel in response to supplied second image signals. The main flexible printed circuit unit is provided below the main display panel while electrically making connection with the main display panel by way of a flexible connector ribbon. The main flexible printed circuit unit includes an integrated circuit that outputs the first image signal to the main display panel, The sub-display panel includes an electrophoresis material layer having at least one set of particles representing a first polarity and a first color, and displays a second image corresponding to the second image signal where positioning of the polarized electrophoretic particles can be controlled by the electric fields defined by the field-defining electrode layer of the main flexible printed circuit unit,

The lowest (base) substrate of the sub-display panel includes a transparent base substrate and a transparent second electrode layer, The base substrate is provided in a region below where the field-defining electrode layer of the main flexible printed circuit unit is formed, and faces the main flexible printed circuit unit. The second electrode layer is interposed between the base substrate and the electrophoresis material layer to output a common voltage. The electrophoresis material layer is interposed between the first, field-defining electrode layer and second electrode layer.

The display apparatus further includes a sideways-illuminating light source that is mounted on and protrudes from the upper major surface of the main flexible printed circuit unit to generate light and to provide the generated light to the main display panel by way of a light guiding plate.

According to the above, the display apparatus therefore includes the sub-display panel that displays the image by using the electrophoresis effect, and uses the main flexible printed circuit unit as an electrodes-supporting substrate of the sub-display panel, thereby reducing the total thickness thereof.

### BRIEF DESCRIPTION OF THE DRAWINGS

The above and other advantages of the presently disclosed apparatus will become more readily apparent by reference to the following detailed description when considered in conjunction with the accompanying drawings wherein:
FIG, 1 is an exploded perspective view showing an exemplary embodiment of a multi-panel display apparatus according to the present disclosure;
FIG. 2 is a plan view showing a connection relationship between a first display panel and a second display panel shown in FIG, 1;
FIG. 3 is a sectional view taken along line I-I' shown in FIG. 1; and
FIG. 4 is a sectional view taken along line II-II' shown in FIG. 2.

### DETAILED DESCRIPTION

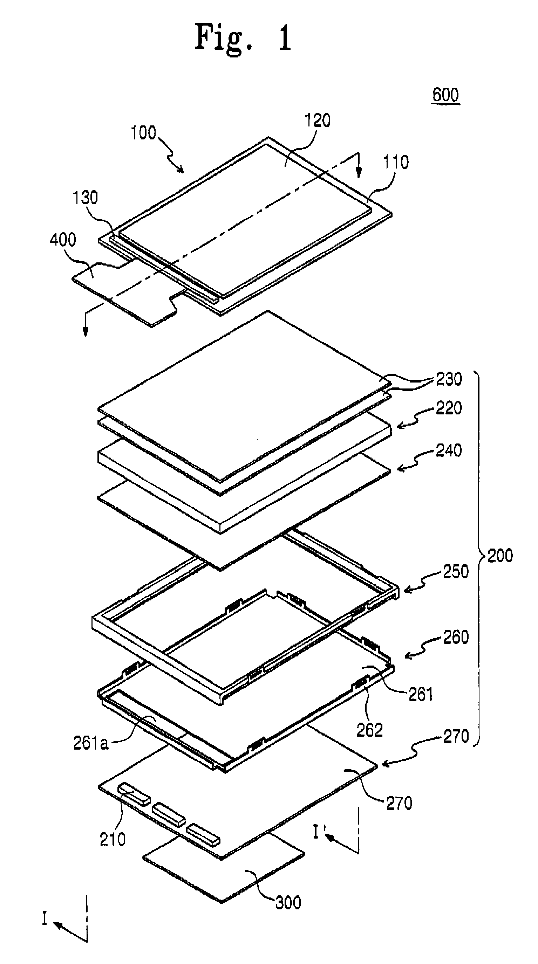

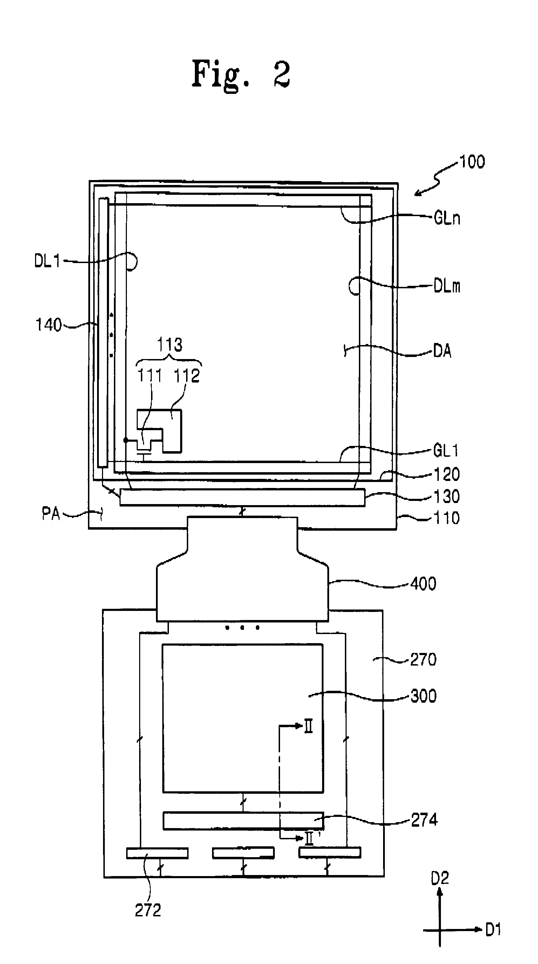

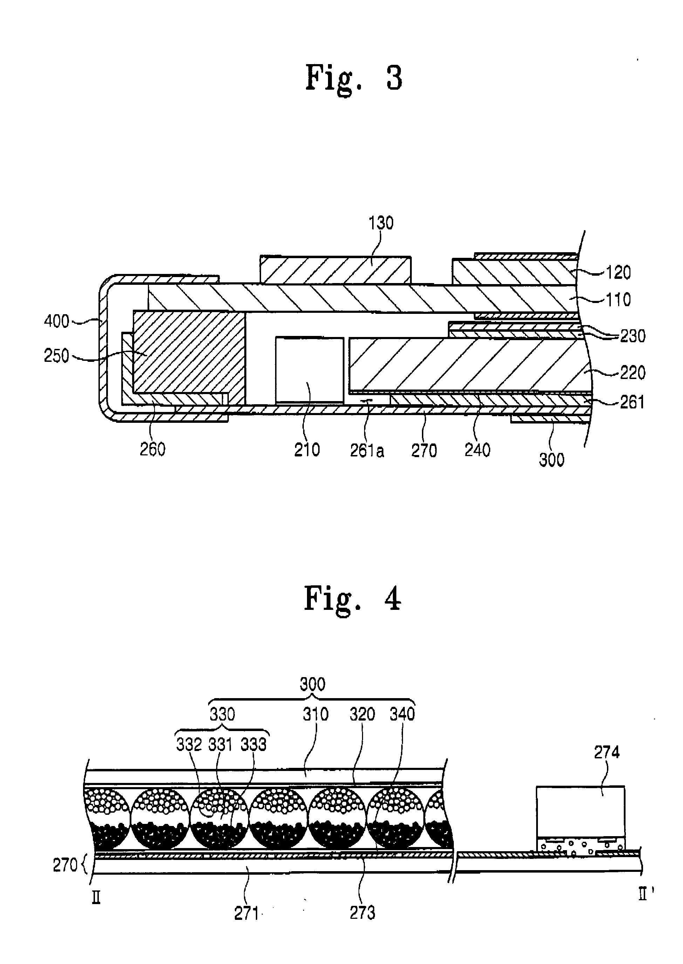

FIG. 1 is an exploded perspective view showing an exemplary embodiment. FIG. 2 is a plan view showing a connection relationship between a first display panel and a second display panel shown in FIG, 1, Of particular note in Fig. 1 is a dual-sided main flexible printed circuit board 270 having light emitting modules 210 projecting upwardly from a top major surface thereof and having field-defining electrodes (not seen in Fig. 1, see instead 273 of Fig. 4) disposed on a bottom major surface thereof. A remaining portion 300 of a sub-display panel combines with the field-defining electrodes to form the sub-display panel. Main image processing IC's (see 272 of Fig. 4) are mounted on the bottom major surface of the dual-sided main flexible printed circuit board 270 and are connected to the first or main-image display panel 100 by way of a folded flexible ribbon connector 400 (shown in folded configuration in Fig. 3).

Referring to details of FIGS. 1 and 2, the multi-panel display apparatus 600 includes the main display panel 100 which is provided for displaying a higher resolution and/or larger main image, a backlight assembly 200 which is provided for uniformly distributing backlighting across a bottom portion of the main display panel 100, and a sub-display panel 300 which is provided for displaying a comparatively lower resolution and/or smaller sub-image in comparison to the main image provided by the upper main display panel 100.

The main display panel 100 receives backlighting from the backlight assembly 200 and in response to supplied first image signals, displays the main image. In detail, the main display panel 100 includes an electronic switch array substrate 110, an opposite electrode substrate 120 spaced apart from the switch array substrate 110 while facing the array substrate 110, a liquid crystal material layer (not shown) interposed between the array substrate 110 and the opposite substrate 120, and direct driving chips 130 and 140 mounted on the array substrate 110 (chip 140 is seen in Fig. 2).

As seen in Fig. 2, the array substrate 110 includes a relatively large display area DA for displaying the main image and a substantially smaller peripheral area PA surrounding the display area DA, where the peripheral area PA is used for supporting the direct driving chips 130 and 140 and making connection with the flexible ribbon cable 400. The array substrate 110 includes a plurality of gate lines GL1 to GLn, a plurality of data lines DL1 to DLm, and pixel units 113 organized as a matrix (where only one unit from the matrix is shown in Fig. 2). The gate lines GL1 to GLn extend in a first direction D1, and the data lines are aligned in a second direction D2 substantially perpendicular to the first direction D1. The gate lines transfer gate signals for selecting display rows while the data lines transfer image signals corresponding to a selected display row of the main image. The data lines , DL1 to DLm are insulated from the gate lines GL1 to GLn by an appropriate dielectric. Areas bounded by the data lines DL1 to DLm and the gate lines GL1 to GLn define a respective plurality of pixel regions through which light is controllably passed to define the main image. The display area DA includes the pixel regions. The one illustrated pixel unit 113 is a basic element of the matrix and is used for forming a corresponding pixel of the main image. Each of the pixel units 113 (only one shown) includes a thin film transistor (TFT) 111 whose gate is electrically connected with a corresponding gate line of the gate lines GL1 to GLn and whose source is electrically connected with a corresponding data line of the data lines DL1 to DLm, and a pixel electrode 112 that is electrically connected with a drain of the thin film transistor 111 so as to develop a pixel controlling voltage between the pixel electrode 112 and the common electrode of an overlying and spaced-apart common substrate 120 (the opposite substrate).

The liquid crystal material layer controls the transmittance of light provided from the backlight assembly 200 according to an electric field formed between the array substrate 110 and the opposite substrate 120, thereby displaying the image, One direct driving chip 130 is mounted in the peripheral area PA of the array substrate 110 adjacent to ends of the data lines as seen in Fig. 2. The driving chip 130 receives data signals representing the first image and outputs analog data signals to the data lines DL1 to DLm for transference via the corresponding TFT pass transistors 111 to respective pixel-electrodes 112. In addition, the driving chip 130 receives synchronization signals and outputs gate control signals to control timing of the gate signals applied to the array substrate 110 from the gate lines driving chip 140. As already mentioned, the direct gate driving chips unit 140 is formed in the peripheral area PA of the array substrate 110 to receive the gate control signals and to output the gate signals to the gate lines GL1 to GLn.

FIG. 3 is a sectional view taken along line I-I' shown in FIG. 1.

Referring to FIGS. 1 to 3, the backlight assembly 200 is provided below the main display panel 100. The backlight assembly 200 includes a plurality of light sources 210 generating multi-colored light (e.g., white light) that is output sideways for coupling into an adjacent light guiding plate 220, where the latter plate 220 distributively guides the edge received light from the light sources toward an upper transparent and major surface of the light guiding plate 220. The backlight assembly 200 further includes optical sheets 230 that are structured to enhance the brightness and/or control the optical polarity of light emitted from the transparent and major surface of the light guiding plate 220. The backlight assembly 200 further includes a reflecting plate 240 that is provided below the light guiding plate 220 to reflect and redirect light trying to escape from the bottom of the light guiding plate 220 back up and out from the transparent and major surface of the light guiding plate 220. The backlight assembly 200 further includes a mold frame 250 that receives the main display panel 100 and the light guiding plate 220; a bottom chassis 260 receiving the mold frame 250; and the above-mentioned dual-sided main flexible printed circuit board 270, The main flexible printed circuit board 270 includes first signal processing circuitry for processing the first image signals corresponding to the main display panel 100 and second signal processing circuitry for processing the second image signals corresponding to the sub-image.

The light sources 210 are provided at one side edge of the light guiding plate 220, and are mounted on an upper surface of the main flexible printed circuit board 270. In one embodiment, the light sources 210 include a plurality of light emitting diodes (LEDs) that emit multiple colors (e.g., red, blue and green) and/or white light, The mold frame 250 has a lower surface partially opened, and receives the light guiding plate 220, the optical sheets 230, the reflecting plate 240, and the main display panel 100. The bottom chassis 260 includes a bottom plate 261 having an opening 261 a and side plates 262 surrounding the bottom plate 261, and receives the mold frame 260,

The main flexible printed circuit board 270 is provided on a lower surface of the bottom plate 261 of the bottom chassis 260, The light source 210 mounted on the main flexible printed circuit board 270 is removably inserted into the mold frame 250 through the opening 261a, so that the light source 210 projects upwardly to be interposed between the light guiding plate 220 and side walls of the mold frame 250 and to couple generated light into the edge of the light guiding plate 220.

FIG. 4 is a sectional view taken along line II-II' shown in FIG. 2.

Referring to FIGS, 2 to 4, the main flexible printed circuit board 270 includes a lower (base) film 271 having a plurality of wires, a plurality of main driving chips 272 (Fig. 2) mounted on a lower surface of the base film 271, a plurality of first electrodes (field electrodes) 273 formed on the lower surface of the base film 271, and a sub-driving chip 274 (Fig. 4) mounted on the lower surface of the base film 271. The light sources 210 (see also FIGS. 2 and 3) are mounted on an upper surface of the base film 271. Printed circuit wirings are provided at least on both sides of the dual sided board 270 for electrically coupling to the various elements including one or more of the aforementioned light sources 210, field electrodes 273, main driving chips 272, sub-driving chip 274, and flexible ribbon cable 400.

The base film 271 may be provided in the form of a relatively thin, planar and somewhat inflexible sheet including resin, where a plurality of sub-pixel regions for displaying the sub-image are partially defined by the field electrodes 273 disposed on the bottom major surface of the base film 271. In other words, the wires are formed on the base film 271 to transfer various signals that are output from the main driving chips 272 and the sub-driving chip 274. The main driving chips 272 output the first image signals to the main display panel 100,

Referring to FIGS. 2 and 3, the display apparatus 600 further includes a sub-flexible printed circuit cable 400 electrically connecting the main flexible printed circuit board 270 with the main display panel 100. The sub-flexible printed circuit 400 is electrically connected with the array substrate 110 and the main flexible printed circuit board 270, thereby providing the driving chip 130 with the first image signals that are output from the main driving chips 272 on the main flexible printed circuit board 270.

Referring again to FIGS, 2 to 4, the sub-driving chip 274 outputs the second image signals to the first electrode layer 273. The first electrode layer 273 is formed on the sub-pixel region. Although not shown in the drawing, the sub-pixel regions may be prepared in the form of an array matrix or a series of segments.

The sub-display panel 300 is coupled to the main flexible printed circuit board 270 while having its sub-image projecting side facing outwardly from the main flexible printed circuit board 270. In detail, the sub-display panel 300 is provided on a lower major surface of the main flexible printed circuit board 270 corresponding to the sub-pixel regions. The sub-display panel 300 includes a transparent lower (base) substrate 310 facing outwardly from the main flexible printed circuit board 270, a second transparent electrode layer 320 outputting a common voltage, an electrophoresis material layer interposed between the first and second electrode layers 273 and 320, and a bonding and/or dielectric sealing member 340 interposed between the electrophoresis material layer and the first electrode layer 273.

The base substrate 310 may include a transparent resin such as Polyethylene Terephthalate (PET), The second electrode layer 320 is formed on an upper surface of the base substrate 310, and includes a transparent conductive material such as Indium Zinc Oxide (IZO) or Indium Tin Oxide (ITO). The electrophoresis layer includes a plurality of micro-capsules each having a substantially spherical shape and being bonded to the second electrode layers 273 by the bonding and/or dielectric sealing member 340, Each of the micro-capsules 330 includes a dispersion medium 331, such as transparent insulating liquid, and polarized particles each having a predefined electrical polarity selected from both plus and minus where at least one of the opposingly polarized particles has a corresponding display color, where the particles are dispersed in the dispersion medium 331, As an example, the micro-capsule 330 includes at least one first particle 332 and at least one second particle 333, The first and second particles 332 and 333 have opposite electrical polarities and colors different from each other,

For instance, the first particle 332 is charged with a positive electrical charge, and includes titanium dioxide TiO₂ so the first particle 332 presents as a white color. Meanwhile, the second particle 333 is charged with a negative electrical charge, and includes carbonaceous powder such as carbon black, so the second particle 333 presents as a black color. Positions of the first and second particles 332 and 333 may be changed according to polarity and strength of an electric field that is selectively generated between the first and second electrode layers 273 and 320.

That is, if a negative electric potential is formed between the first electrode layer 273 and the second electrode layer 320, the second particles 333 move toward the first electrode layer 273 and the first particles 332 move toward the second electrode layer 320, so that the white color is displayed. Whereas, if a positive electric potential is formed between the first electrode layer 273 and the second electrode layer 320, the first particles 332 move toward the first electrode layer 273 and the second particles 333 move toward the second electrode layer 320, so that the black color is displayed. The electric potential is formed between the first electrode layer 273 and the second electrode layer 320 on each sub-pixel region, so that the position of the first and second particles 332 and 333 may be differently set in each sub-pixel region.

The bonding member 340 bonds the sub-display panel 300 to the main flexible printed circuit board 270, thereby fixing the sub-display panel 300 to the main flexible printed circuit board 270. As an example of the present disclosure, the sub-display panel 300 is prepared in the form of a film having a thickness smaller than a thickness of the main display panel 100.

As described above, the sub-display panel 300 includes the particles having opposed polarities to selectively display the sub-image using the electrophoresis effect, and uses the field electrodes 273 of the main flexible printed circuit board 270 as a lower field-defining substrate. In addition, the sub-display panel 300 is prepared in the form of a film, so the thickness of the sub-display panel 300 is thinner than that of the main display panel 100. Ambient light may be used to view the sub-image formed by the sub-display panel 300. Accordingly, the display apparatus 600 does not require an additional light source and lower substrate to drive the sub-display panel, thereby reducing the total thickness and the power consumption thereof.

According to the above, the display apparatus includes the sub-display panel, which is prepared in the form of a film including charged particles, and uses the main flexible printed circuit board as the lower substrate thereof. Accordingly, the display apparatus does not require the additional light source and lower substrate to drive the sub-display panel, thereby reducing the entire thickness thereof.

Although the exemplary embodiments of the present disclosure have been described, it is understood that the present disclosure should not be limited to these exemplary embodiments but various changes and modifications can be made by one ordinary skilled in the art in light of and within the spirit and scope of the present disclosure.

## Claims

1. A display apparatus comprising:
a main display panel structured to display a first image corresponding to a supplied first image signal;
a main printed circuit unit that has a first electrode layer for generating electrical fields for displaying a second image corresponding to a supplied second image signal, the first electrode layer being disposed on a lower major surface of the main printed circuit unit, where the main printed circuit unit is in electrical communication with the main display panel, and outputs a display driving signal corresponding to the first image signal to the main display panel; and
a sub-display panel comprising an electrophoresis layer having at least one set of polarized electrophoretic particles of a predefined first polarity and a predefined color, in which the sub-display panel is in operative communication with the generated electrical fields of the first electrode layer and displays a second image corresponding to the second image signal.

2. The display apparatus of claim 1, wherein the sub-display panel comprises:
a base substrate faces the main printed circuit unit, and
a second electrode layer that is interposed between the base substrate and the electrophoresis layer and outputs a common voltage,
wherein the electrophoresis layer is interposed between the first and second electrode layers.

3. The display apparatus of claim 2, wherein the sub-display panel further comprises a bonding member that is Interposed between the electrophoresis layer and the first electrode layer to bond the second display panel to the main printed circuit unit.

4. The display apparatus of claim 1, wherein the electrophoresis layer comprises a plurality of micro-capsules that are formed by encapsulating the particle.

5. The display apparatus of claim 1, further comprising a driver that is mounted on the main printed circuit unit and outputs the second image signal to the first electrode layer.

6. The display apparatus of claim 1, further comprising a sub-flexible printed circuit unit that electrically connects the main printed circuit unit with the main display panel, and provides the first image signal from the main printed circuit unit to the main display panel.

7. The display apparatus of claim 1, further comprising at least one light source that is mounted on an upper surface of the main printed circuit unit and generates the light to provide the light to the main display panel.

8. The display apparatus of claim 1, wherein the main display panel comprises:
an array substrate that includes at least one pixel unit prepared in a form of an array to receive the first image signal; and
an opposite substrate that faces the array substrate and receives the common voltage corresponding to the first image signal.

9. The display apparatus of claim 1, wherein the main printed circuit unit comprises a flexible printed circuit board,

10. A multi-layer printed circuit board for use with a multi-panel display comprising a first display panel for displaying a first image and a second display panel for displaying a different second image, where the multi-layer printed circuit board has:
a first major surface structured to be positioned beneath the first display panel;
a second major surface structured to be disposed above the second display panel, the second major surface having a plurality of field generating electrodes disposed thereon for generating electrical fields that act upon the second display panel and thereby cause the second display panel to display the second image;
where the first major surface includes a light sourcing mounting area for supporting and electrically driving a light sourcing unit which supplies light for backlighting of the first display panel.

11. The multi-layer printed circuit board of Claim 10 and further wherein:
the second major surface includes a flexible cable contacting area for securing and making electrical contact to a flexible cable that electrically connects with the first display panel.

12. The multi-layer printed circuit board of Claim 11 and further wherein:
the second major surface includes a main display circuit mounting area for supporting and electrically driving a main display circuit that is couplable to the first display panel by way of the flexible cable.

13. The multi-layer printed circuit board of Claim 11 and further wherein:
the second major surface includes a secondary display circuit mounting area for supporting and electrically driving a second display circuit so that when mounted on the multi-layer printed circuit board, the second display circuit is operatively coupled to the field generating electrodes for causing the field generating electrodes to generate said electrical fields that act upon the second display panel.

14. The multi-layer printed circuit board of Claim 12 wherein the first display panel includes a liquid crystal layer and wherein the second display panel includes electrophoretic particles that can be moved by said electrical fields that act upon the second display panel.

15. The multi-layer printed circuit board of Claim 10 wherein the first display panel includes a liquid crystal layer and wherein the second display panel includes electrophoretic particles that can be moved by said electrical fields that act upon the second display panel.
